# FASCICULE DE BREVET EUROPEEN

(11) **EP 1 407 486 B1**
(45) Date de publication et mention de la délivrance du brevet: **09.06.2010**
(21) Numéro de dépôt: 02764986.2
(22) Date de dépôt: 16.07.2002
(51) Int. Cl.: H01L 21/336, H01L 29/786, H01L 29/423

(54) **PROCEDE DE FABRICATION D'UN TRANSISTOR SUR UN SUBSTRAT SOI**
HERSTELLUNGSVERFAHREN FÜR EINEN TRANSISTOR AUF EINEM SOI-SUBSTRAT
METHOD FOR MAKING A TRANSISTOR ON A SOI SUBSTRATE

(30) Priorité: 19.07.2001 FR 0109665
(43) Date de publication de la demande: 14.04.2004
(73) Titulaire: Commissariat à l'énergie atomique et aux énergies alternatives, 75015 Paris (FR)
(72) Inventeur: JOLY, Jean-Pierre, F-38120 SAINT EGREVE (FR)
(74) Mandataire: Poulin, Gérard
(86) Numéro de dépôt international: PCT/FR2002/002523
(87) Numéro de publication internationale: WO 2003/009404

(56) Documents cités:
- DE-A- 4 447 149
- FR-A- 2 774 214
- US-A- 4 660 062
- US-A- 5 846 862
- US-A- 6 054 355
- GODBEY D J ET AL: "SELECTIVE REMOVAL OF SI1-XGEX FROM (100) SI USING HNO3 AND HF" JOURNAL OF THE ELECTROCHEMICAL SOCIETY, ELECTROCHEMICAL SOCIETY. MANCHESTER, NEW HAMPSHIRE, US, vol. 139, no. 10, 1 octobre 1992 (1992-10-01), pages 2943-2947, XP000359007 ISSN: 0013-4651

## Description

### Domaine technique

La présente invention concerne un procédé de réalisation d'un transistor à effet de champ de type MOS (transistor à grille isolée).

L'invention trouve des applications, de façon générale, dans les domaines de la microélectronique et de l'électronique de commutation. Elle vise en particulier la réalisation de transistors susceptibles de fonctionner à des fréquences élevées.

### Etat de la technique antérieure.

Les transistors à commutation rapide, c'est-à-dire les transistors susceptibles de fonctionner à des fréquences élevées, présentent généralement des canaux courts et suffisamment fins pour autoriser leur appauvrissement complet. Aussi, pour leur réalisation, on a recours de préférence à des substrats de type silicium sur isolant (SOI). Ces substrats ont la particularité de présenter une couche mince de silicium, séparée d'un substrat massif par une couche enterrée isolante, par exemple, d'oxyde de silicium. Le canal du transistor, de même que la source et le drain, sont alors formés dans la couche mince.

Une technique bien connue pour la réalisation de substrats de type silicium sur isolant, consiste à reporter sur un substrat receveur, comprenant une couche superficielle d'oxyde de silicium, un bloc de silicium donneur, et de fracturer ce bloc selon une zone fragilisée pour en détacher une couche mince. La couche mince de silicium reste solidaire de la couche d'oxyde de silicium qui se trouve ainsi être enterrée.

Bien que d'autres solutions puissent être retenues, la zone fragilisée du bloc de silicium est préférentiellement réalisée par implantation d'ions d'hydrogène et/ou de gaz rares. Ainsi, l'épaisseur de la couche mince est dictée par la profondeur, partant l'énergie d'implantation, de la zone fragilisée or, il s'avère que cette technique ne permet pas d'obtenir des couches de silicium dont l'épaisseur n'excède pas quelques nanomètres et qui puisse être contrôlée avec une bonne précision. Après le report, la couche de silicium présente, en effet, une certaine rugosité, ou tout au moins des défauts de surface.

Pour garantir une meilleure précision de l'épaisseur de la couche de silicium, ainsi qu'une bonne qualité de surface, une autre technique consiste à faire croître la couche de silicium par épitaxie sur une couche de matériau tel que le SiGe, avant son report d'un substrat donneur vers le substrat receveur. Le report a lieu en laissant la couche mince de silicium solidaire de tout ou partie de la couche de SiGe, et éventuellement une partie du substrat donneur. En d'autres termes, la zone fragilisée n'est pas formée dans le silicium mais dans la couche de SiGe ou le substrat sous-jacents. Après le report, le reliquat de la couche de SiGe, de même qu'éventuellement le reliquat du substrat donneur, sont éliminés par une gravure. La gravure est opérée avec des agents de gravure sélectifs par rapport au silicium de façon à pouvoir utiliser la couche mince de silicium comme couche d'arrêt de gravure.

Au terme de la gravure, la couche mince de silicium, solidaire de la couche d'oxyde du substrat receveur, présente une face entièrement libre. Ainsi, l'épaisseur de la couche n'est pas dictée par la fracture d'un substrat donneur mais par l'épitaxie. Or, l'épitaxie permet d'obtenir des couches particulièrement minces et de contrôler parfaitement leur épaisseur.

La minceur de la couche de silicium permet de réduire aussi la longueur du canal et donc de miniaturiser le transistor. Par ailleurs une couche de silicium très mince permet de concevoir des transistors « bi-dimensionnels » avec un très fort appauvrissement du canal. Les performances en fréquence des transistors s'en trouvent améliorées. En revanche, et toujours en raison de la faible épaisseur de la couche de silicium, la résistance d'accès aux source et drain tend à augmenter et constitue une nouvelle limite des performances des transistors.

Une illustration de l'état de la technique peut être trouvée, par exemple dans les documents (1) et (2) dont les références sont précisées à la fin de la présente description.

### Exposé de l'invention.

L'invention a pour but de proposer un procédé de réalisation d'un transistor, ne présentant pas les difficultés ou limitations mentionnées ci-dessus.

Un but est en particulier de proposer un procédé permettant de contrôler avec une grande précision l'épaisseur et la longueur du canal.

Un autre but encore est de proposer un transistor avec des résistances d'accès réduites aux source et drain.

Pour atteindre ces buts, l'invention a plus précisément pour objet un procédé comprenant les étapes selon la revendication 1.

Dans ce procédé la couche dite superficielle, est une couche présentant un paramètre de maille voisin de celui du silicium. Elle a plusieurs fonctions. Une première fonction est d'autoriser une gravure sélective par rapport au silicium. Une deuxième fonction est d'augmenter le volume des source et drain, en les surélevant, de façon à réduire leur résistance d'accès. Enfin, lorsqu'elle présente un paramètre de maille proche du silicium, une troisième fonction est de favoriser la croissance par épitaxie d'une couche mince de silicium, avec une épaisseur contrôlée.

La couche superficielle est de préférence une couche de SiGe. Toutefois, d'autres matériaux semiconducteurs tels que, par exemple, le SiC ou des alliages de type SiₓGe_{y}C_{1-x-y}, GaₓP₁₋ₓ ou GaₓIn₁₋ₓN_{y}As_{1-y} peuvent également convenir.

La gravure locale de la couche superficielle revient à pratiquer dans cette couche un puits à l'endroit où sera formée la future grille. Il convient de noter à sujet que, bien que la description se réfère essentiellement à la fabrication d'un seul transistor, une pluralité de transistors peuvent être fabriqués de façon concomitante. Dans ce cas, la gravure est réalisée selon un motif permettant de mettre à nu la couche mince dans une pluralité de régions de canal, chacune de ces régions étant ensuite pourvue d'une grille, et associée à des source et drain.

La gravure de la couche superficielle est préférentiellement une gravure anisotrope par voie sèche. Toutefois, lorsque la couche de silicium est particulièrement mince, ou lorsqu'on veut en éviter toute altération, il possible de réaliser une première gravure anisotrope, par voie sèche, et une deuxième gravure par voie humide, la gravure par voie sèche étant interrompue avant l'élimination complète de la couche superficielle dans la région de canal. La deuxième gravure, qui présente une sélectivité supérieure à la première gravure, est poursuivie avec arrêt sur la couche de silicium.

En effet, les gravures par voie humide, présentent généralement une meilleure sélectivité que les gravures par voie sèche, mais sont souvent isotropes.

Les source et drain sont formées non seulement dans la couche mince de silicium, mais également dans des régions sus-jacentes de la couche superficielle, de part et d'autre du canal. Bien que d'autres techniques, telles que la diffusion, peuvent être retenues, les régions de source et de drain sont de préférence formées par implantation d'impuretés dopantes. L'implantation peut être suivie d'un traitement thermique d'activation.

Pour obtenir un parfait alignement des source et drain sur la grille, celle-ci peut être formée avant les source et drain, et mise à profit comme masque d'implantation. Dans ce cas toutefois, la grille est susceptible d'être soumise au traitement d'activation. Un choix de matériaux réfractaires pour la grille permet d'éviter cette contrainte. Lorsqu'elle doit subir un traitement thermique, la grille peut être réalisée, par exemple, en silicium polycristallin, ou en un matériau plus fragile, tel que le cuivre, mais protégé par un matériau réfractaire.

Selon un perfectionnement, la réalisation de la grille peut aussi comporter les étapes suivantes :
- la formation d'une grille factice sur la couche de silicium dans la région de canal,
- l'implantation d'impuretés dopantes dans la couche de silicium et la couche superficielle, en utilisant la grille factice comme masque d'implantation, et
- le remplacement de la grille factice par une grille définitive, isolée par une couche de diélectrique de grille.

Comme les grilles sont toujours formées dans le puits obtenu par gravure au-dessus de la région de canal, les source et drain conservent leurs propriétés d'alignement lors du remplacement de la grille factice par la grille définitive. De plus, les matériaux de la grille factice et de la grille définitive peuvent être choisis plus librement en fonction d'éventuelles contraintes de fabrication. Par exemple, la grille factice peut être réalisée en un matériau capable de parfaitement résister aux contraintes thermiques d'un éventuel traitement d'activation des impuretés dopantes. Par ailleurs, le matériau de la grille définitive, affranchi de toute contrainte thermique, peut être choisi, par exemple, en fonction de son travail de sortie en vue d'une faible tension de seuil du transistor.

Conformément à une mise en oeuvre particulière de l'invention, le dépôt du matériau de grille, et notamment le dépôt du matériau de la grille définitive, peut être suivi d'une ou de plusieurs opérations de planage avec arrêt sur, ou dans, la couche dite superficielle. Le planage permet d'obtenir une grille encastrée damascène.

Le support isolant peut être un support massif, tel qu'un bloc de verre ou de saphir, mais peut aussi se résumer à une simple couche isolante solidaire d'un substrat qui ne l'est pas nécessairement. Il s'agit, par exemple, d'une couche d'oxyde de silicium recouvrant un bloc de silicium massif.

D'autres caractéristiques et avantages de l'invention ressortiront de la description qui va suivre, en référence aux figures des dessins annexés. Cette description est donnée à titre purement illustratif et non limitatif.

### Brève description des figures

La figure 1, représente, sous la forme de coupes schématiques, des substrats donneur et receveur, pour la fabrication d'un substrat propre à la mise en oeuvre d'un procédé conforme à l'invention.

Les figures 2 et 3 sont des coupes schématiques d'un substrat obtenu suite à l'étape de procédé correspondant à la figure 1, et illustrent une étape de gravure pour la définition d'une région de canal d'un transistor.

La figure 4, est une coupe schématique du substrat obtenu suite à l'étape de procédé correspondant à la figure 3, et illustre la réalisation d'une source et d'un drain du transistor.

La figure 5, est une coupe schématique du substrat obtenu suite à l'étape de procédé correspondant à la figure 4, et illustre la réalisation d'une grille du transistor.

### Description détaillée de modes de mise en oeuvre de l'invention.

Dans la description qui suit, des parties identiques, similaires ou équivalentes des différentes figures sont repérées par les mêmes signes de référence pour faciliter le report entre les figures. Par ailleurs, et dans un souci de clarté des figures, tous les éléments ne sont pas représentés selon une échelle uniforme.

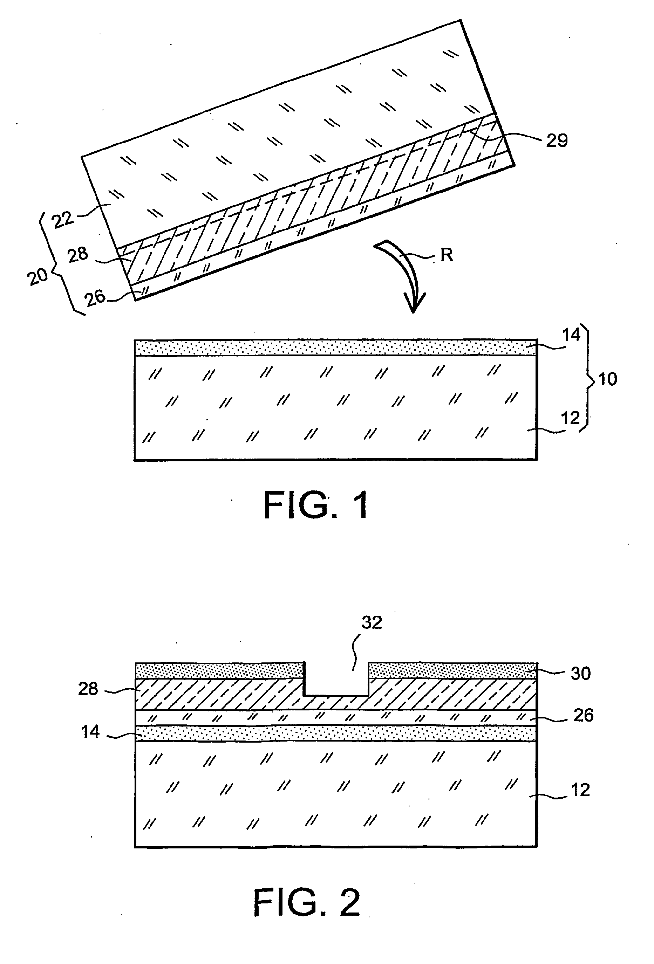

La figure 1 illustre la formation d'un substrat adapté à la fabrication d'un transistor conforme à l'invention. Un premier substrat receveur 10 comprend un bloc de support 12, en silicium massif, recouvert d'une couche d'oxyde de silicium 14. La couche d'oxyde de silicium, utilisée pour ses propriétés d'isolant électrique, constitue le «support isolant» auquel il est encore fait allusion. A titre de variante, le bloc de support recouvert d'une couche isolante peut être remplacé par un bloc de matériau isolant massif.

Un deuxième substrat, désigné par substrat donneur, comprend également un bloc de support 20, et sur ce bloc, une couche de SiGe 28, et une couche mince de silicium 26 préférentiellement monocristalline. La couche mince de silicium 26 est formée par épitaxie sur la couche de SiGe, de façon à pouvoir contrôler avec précision son épaisseur. Celle-ci est comprise, par exemple entre 1 et 20 nm.

Dans l'exemple illustré par les figures, et décrit ici, le SiGe est choisi notamment pour sa propriété de présenter un paramètre de maille suffisamment voisin du silicium pour autoriser la croissance d'une couche cristalline de bonne qualité, et pour sa propriété de pouvoir être gravé sélectivement par rapport au silicium.

La référence 29 désigne une zone fragilisée formée dans la couche de SiGe. Elle est formée, par exemple, par implantation ionique.

Une flèche R indique le report du substrat donneur 20 sur le substrat receveur 10. Le report comprend la fixation de la couche mince 26 contre la couche d'oxyde de silicium 14. Celle-ci fait office de support isolant. La fixation peut avoir lieu avec ou sans matériau intermédiaire, il s'agit, par exemple d'un collage par adhésion moléculaire directe.

Le report du substrat donneur sur le substrat receveur est suivi par la fracture du substrat donneur, selon la zone fragilisée 29. La fracture a pour effet d'en détacher la couche mince de silicium, désormais solidaire du substrat receveur, et de tout ou partie de la couche 28 de SiGe qui recouvre la couche de silicium. A ce titre, la couche de SiGe est encore désignée par «couche superficielle». La zone fragilisée 29 peut éventuellement être formée hors de la couche de SiGe, par exemple, dans le bloc de support 22. Cependant, il est important de noter que la zone fragilisée ne délimite pas la couche mince de silicium, prise isolément. Ainsi, lors de son report sur le substrat récepteur, la couche de silicium mince 26 n'est aucunement altérée.

Comme le montre la figure 2, après la fracture et l'élimination de la partie restante du substrat donneur, un masque de gravure 30 est formé sur la face libre de la couche superficielle 28. Il s'agit d'un masque de résine. Le masque 30 présente une ouverture 32 correspondant à l'emplacement du canal d'un transistor que l'on souhaite former sur le substrat. Bien que les figures se limitent à la réalisation d'un transistor unique, une pluralité de transistors peuvent être formés sur le même substrat. Dans ce cas, la couche de masque de gravure présente une ouverture correspondant au canal de chaque transistor que l'on souhaite réaliser.

La couche superficielle 28 est soumise à une première gravure anisotrope, à travers l'ouverture 32 de la couche de masque. Il s'agit d'une gravure par voie sèche. Dans cet exemple particulier, une atmosphère de gaz actif CF4 à 10 sccm, mélangé à de l'azote à 200 sccm, sous une pression de 1 Torr est utilisée. L'un au moins des paramètres de la gravure sèche, par exemple sa durée, est choisi pour interrompre la gravure de la couche superficielle 28 de SiGe avant que la couche mince de silicium 26 sous-jacente ne soit atteinte.

La première gravure est suivie d'une deuxième gravure isotrope, par voie humide. Les agents de gravure utilisés sont choisis de façon à éliminer sélectivement le SiGe par rapport au silicium. Toujours à titre d'exemple, on peut utiliser un mélange HNO₃, H₂O et HF qui, selon la concentration en germanium de la couche superficielle, permet d'atteindre des sélectivités de l'ordre de 100. On peut se référer à ce sujet au document (3) dont les références sont précisées à la fin de la description. La très bonne sélectivité de la deuxième gravure par voie humide, permet de conserver parfaitement l'épaisseur et la qualité de surface de la couche mince de silicium 26.

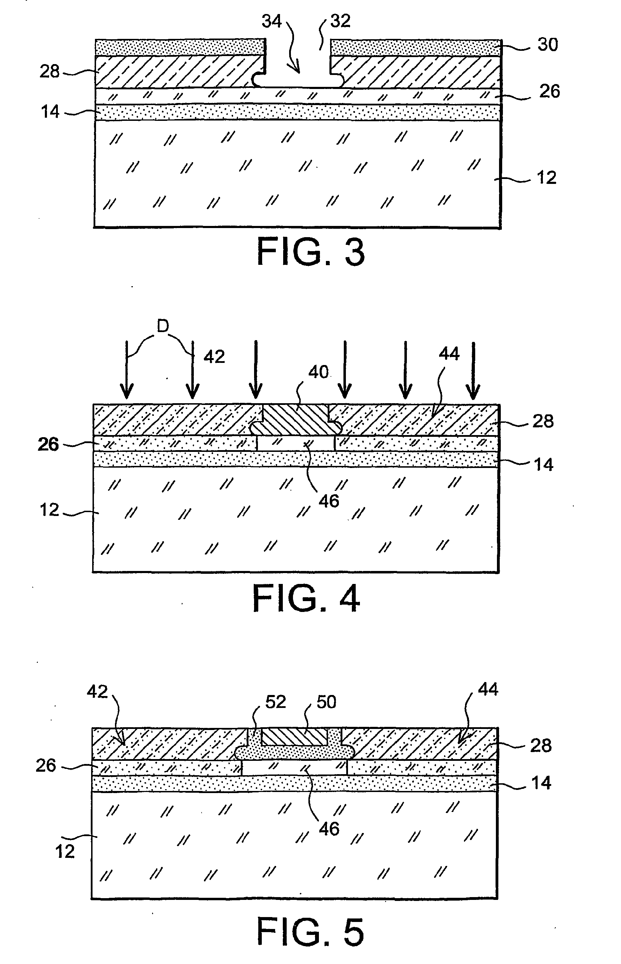

Comme le montre la figure 3, la deuxième gravure est poursuivie avec arrêt sur la couche mince de silicium 26. Celle-ci est mise à nu au fond d'un puits 34 dont les flancs latéraux sont ajustés sur l'ouverture 32 du masque de gravure. Plus précisément, la partie supérieure des flancs est alignée à l'aplomb de l'ouverture 32, tandis que la partie inférieure, au voisinage de la couche mince présente un léger évasement. Cet évasement est dû au caractère isotrope de la seconde gravure.

L'évasement peut être évité en pratiquant une ou plusieurs gravures exclusivement anisotropes. Les gravures anisotropes présentent toutefois une moins bonne sélectivité, et doivent donc être contrôlées avec un plus grand soin pour préserver la couche de silicium 26.

La figure 4 montre la réalisation des source et drain.

Dans un premier temps, une grille factice 40, par exemple en un matériau tel que le nitrure de silicium, est formée dans le puits précédemment gravé. La grille factice est encastrée et affleure à la surface de la couche superficielle 28.

Ceci peut être obtenu en déposant le matériau de la grille sur l'ensemble de la surface du substrat, avec une épaisseur suffisante pour combler le puits, puis en effectuant un planage, par exemple un polissage mécano-chimique, avec arrêt sur ou dans la couche superficielle 28.

Le substrat est ensuite soumis à une implantation D d'impuretés dopantes en utilisant la grille factice comme masque d'implantation. L'implantation a lieu dans la couche mince de silicium 26 et dans la couche superficielle de SiGe 28. Elle s'étend de part et d'autre de la grille factice pour former une source 42 et un drain 44. La grille factice protège une partie sous-jacente de la couche mince qui constitue le canal 46 du transistor. Les source et drain sont ainsi auto-alignés sur la grille factice 40 et donc sur le canal 46.

Un masque d'implantation, non représenté, peut éventuellement être prévu aussi pour limiter l'extension des source et drain ou pour en définir la forme en dehors du transistor.

L'implantation des impuretés dopantes est suivie d'un traitement thermique d'activation. Le traitement thermique permet aussi de faire diffuser les impuretés dopantes et minimiser la résistance électrique des source et drain, notamment à l'interface Si/SiGe.

La figure 5 montre le remplacement de la grille 40 factice par une grille définitive 50. La grille factice est éliminée, par gravure sélective, pour réouvrir le puits. Cette opération est suivie par la formation d'une couche d'isolant de grille 52, puis d'une grille 50.

La couche d'isolant de grille 52, formée par dépôt ou par oxydation, tapisse les parois du puits de façon à isoler la grille du canal 46, mais aussi des source et drain 42, 44. Comme pour la grille factice, la formation de la grille définitive comprend le dépôt d'un matériau suivi d'un planage. La grille définitive est ainsi encastrée et affleure également à la surface de la couche superficielle 28. Comme la grille définitive occupe l'emplacement de la grille factice, les source et drain restent auto-alignés sur la grille définitive. De plus, la grille définitive ne subit, dans cet exemple de réalisation, aucun traitement thermique. Elle est, par exemple, en cuivre ou en W ou un bicouche TiN/Cu.

Selon une variante, on peut aussi former directement la grille définitive et utiliser cette grille comme masque d'implantation des source et drain. Le recours à une grille factice est alors inutile. Dans ce cas, et lorsqu'on souhaite soumettre les régions implantées à un traitement thermique, la grille est préférentiellement réalisée en un matériau conducteur réfractaire tel que le silicium polycristallin ou un siliciure, par exemple du siliciure de tungstène.

### Documents cités

***(1)*** FR-A-2 774 214
***(2)*** K.D. Hobart, "Conference abstract NATO Advanced Research Workshop, "Progress in SOI structures and device operating at extreme conditions", pp.63-64.
***(3)*** J. Electrochem. Soc. Vol. 139, n° 10, octobre 92, "Selective removal of Si1-xGex from (100) si using HNO3 and HF", D.J. Godbey, A.H. Krist, K.D. Hobart, and M.E. Twigg.

## Revendications

1. Procédé de fabrication d'un transistor de type MOS comprenant les étapes suivantes :
a) la fourniture d'un substrat receveur (10), comprenant une couche mince de silicium (26), solidaire d'un support isolant (14), et recouverte d'une couche superficielle (28) en un matériau semi-conducteur,
b) la gravure locale de la couche superficielle (28) pour mettre à nu la couche de silicium dans au moins une région de canal,
c) la formation d'une grille isolée (50) au-dessus de la couche de silicium (26) dans la région de canal, et la formation d'une source et d'un drain (42, 44) de part et d'autre de la région de canal, les source et drain s'étendant dans la couche de silicium et dans la couche superficielle,
dans lequel l'étape a) comporte :
- la formation, sur un substrat donneur (20), de la couche superficielle (28) en un matériau présentant un paramètre de maille voisin du silicium,
- la formation, par épitaxie, d'une couche mince de silicium (26) sur la couche superficielle (28), et
- le report de la couche mince de silicium et d'au moins une partie de la couche superficielle sur le support isolant (14), en rendant la couche mince de silicium (26) solidaire dudit support isolant (14).

2. Procédé selon la revendication 1, dans lequel l'étape c) comprend :
- la formation d'une grille factice (40) sur la couche de silicium dans la région de canal,
- l'implantation d'impuretés dopantes (D) dans la couche de silicium et la couche superficielle, en utilisant, la grille factice comme masque d'implantation, et
- le remplacement de la grille factice par une grille définitive (50), isolée par une couche de diélectrique de grille (52).

3. Procédé selon la revendication 2, dans lequel on forme la grille définitive (50) par dépôt d'un matériau de grille sur une couche de diélectrique de grille, puis par planage du matériau de grille jusqu'à rendre la grille affleurante à la couche superficielle (28).

4. Procédé selon la revendication 1, dans lequel l'étape c) comporte :
- la réalisation d'une grille définitive (50) , en un matériau réfractaire, et
- l'implantation d'impuretés dopantes, en utilisant la grille définitive comme masque d'implantation, pour former les régions de source et de drain.

5. Procédé selon la revendication 1, dans lequel le report comprend la fracture de l'un de la couche superficielle et du substrat donneur.

6. Procédé selon la revendication 1, dans lequel le matériau de la couche superficielle est du SiGe ou du Sic, SiₓGe_{y}C_{1-x-y}, GaₓP₁₋ₓ, GaₓIn₁₋ₓN_{y}As_{1*-*y.}

7. Procédé selon la revendication 1, dans lequel l'étape b) comporte une première gravure anisotrope, par voie sèche, et une deuxième gravure par voie humide, la gravure par voie sèche étant interrompue avant l'élimination complète de la couche superficielle (28) dans la région de canal, et la deuxième gravure, présentant une sélectivité supérieure à la sélectivité de la première gravure, est poursuivie avec arrêt sur la couche de silicium (26).

## Claims

1. A process for producing a transistor of MOS type, comprising the following steps:
a) providing a receiver substrate (10) comprising a thin layer of silicon (26), integral with an insulating support (14), and covered with a superficial layer (28) of a semi-conductor material,
b) local etching of the superficial layer (28) to expose the silicon layer in at least one channel region,
c) forming an insulated gate (50) above the silicon layer (26) in the channel region, and forming a source and a drain (42, 44) on either side of the channel region, the source and drain extending in the layer of silicon and in the superficial layer,
wherein step a) comprises:
- forming, on a donor substrate (20), the superficial layer (28) made of a material having a unit cell parameter close to silicon,
- forming, by epitaxy, a thin layer of silicon (26) on the superficial layer, and
- transferring the thin silicon layer and at least one portion of the superficial layer on the insulating support (14), by making the thin layer of silicon (26) integral with said insulating support (14).

2. The process as claimed in Claim 1, wherein step c) comprises:
- forming a bogus gate (40) on the layer of silicon in the channel region,
- implantating doping impurities (D) in the layer of silicon and the superficial layer, by using the bogus gate as an implantation mask, and
- replacing the bogus gate by a definitive gate (50), insulated by a gate dielectric layer (52).

3. The process as claimed in Claim 2, wherein the definitive gate (50) is formed by depositing a gate material on a gate dielectric layer, then by planarizing the gate material until the gate brushes the superficial layer (28).

4. The process as claimed in Claim 1, wherein step c) comprises:
- producing a definitive gate (50), made of a refractory material, and
- implanting doping impurities, by using the definitive gate as an implantation mask to form the source and drain regions.

5. The process as claimed in Claim 1, wherein the transfer comprises the fracture of one of the superficial layer and of the donor substrate.

6. The process as claimed in Claim 1, wherein the material of the superficial layer is SiGe or SiC, SiₓGe_{y}C_{1-x-y}, CaₓP₁₋ₓ, CaₓIn₁₋ₓN_{y}As_{1-y}.

7. The process as claimed in Claim 1, wherein step b) comprises a first dry, anisotropic etching, and a second wet etching, the dry etching being interrupted before complete elimination of the superficial layer (28) in the channel region, and the second etching having a selectivity greater than the selectivity of the first etching and being followed up with a stop on the silicon layer (26).

## Patentansprüche

1. Verfahren zur Herstellung eines MOS-Transistors, die folgenden Schritte umfassend:
a) das Ausrüsten eines Empfängersubstrats (10), umfassend eine mit einer isolierenden Auflage (14) vereinigte dünne Siliciumschicht (26), überzogen von einer Oberflächenschicht (28) aus einem Halbleitermaterial,
b) das lokale Ätzen der Oberflächenschicht (28), um die Siliciumschicht in wenigstens einem Kanalbereich freizulegen bzw. zu ätzen,
c) das Bilden eines isolierten Gates (50) über der Siliciumschicht (26) in dem Kanalbereich, und Bindung einer Source und eines Drains (42, 44) beiderseits des Kanalbereichs, wobei die Source und das Drain sich in der Siliciumschicht und in der Oberflächenschicht erstrecken,
bei dem der Schritt a) umfasst:
- das Bilden der Oberflächenschicht (28) aus einem Material mit einem dem Silicium ähnlichen Maschenparameter auf dem Gebersubstrat (20),
- das Bilden einer Silicium-Dünnschicht (26) auf der Oberflächenschicht (28), und
- die Übertragung der Silicium-Dünnschicht und wenigstens eines Teils der Oberflächenschicht auf die isolierende Auflage (14), indem man die Silicium-Dünnschicht (26) mit der genannten Auflage (14) vereinigt.

2. Verfahren nach Anspruch 1, bei dem der Schritt c) umfasst:
- das Ausbilden einer Gate-Attrappe (40) auf der Siliciumschicht in dem Kanalbereich,
- das Implantieren von Dotierverunreinigungen (D) in die Siliciumschicht und die Oberflächenschicht, wobei die Gate-Attrappe als Implantationsmaske benutzt wird, und
- das Ersetzen der Gate-Attrappe durch ein definitives Gate (50), isoliert durch eine Gatedielektrikum-Schicht (52).

3. Verfahren nach Anspruch 2, bei dem man das definitive Gate (50) bildet, indem man ein Gate-Material auf einer Gatedielektrikum-Schicht abscheidet, dann das Gate-Material planarisiert, bis das Gate mit der Oberflächenschicht (28) bündig ist.

4. Verfahren nach Anspruch 1, bei dem der Schritt c) umfasst:
- das Realisierten einer Gate-Attrappe (50) aus einem refraktären Material, und
- das Implantieren von Dotierverunreinigungen, wobei man das definitive Gate als Implantationsmaske benutzt, um die Source- und Drain-Bereiche zu bilden.

5. Verfahren nach Anspruch 1, bei dem die Übertragung das Brechen von einem, der Oberflächenschicht und bzw. oder des Gebersubstrats, umfasst.

6. Verfahren nach Anspruch 1, bei dem das Material der Oberflächenschicht SiGe oder SiC, SiₓGe_{y}C_{1-x-y}, GaₓP₁₋ₓ, GaₓIn₁₋ₓN_{y}As_{1-y} ist.

7. Verfahren nach Anspruch 1, bei dem der Schritt b) eine anisotrope trockene erste Ätzung und eine nasse zweite Ätzung umfasst, wobei die trockene Ätzung vor der kompletten Eliminierung der Oberflächenschicht (28) in dem Kanalbereich abgebrochen wird, und die zweite Ätzung, die eine größere Selektivität als die erste Ätzung aufweiset, weitergeht, mit Halt auf der Siliciumschicht (26).
